(19) Europäisches Patentamt
European Patent Office
Office européen des brevets

(11) **EP 2 893 554 B1**

(12) **FASCICULE DE BREVET EUROPEEN**

(45) Date de publication et mention
de la délivrance du brevet:
**02.01.2019 Bulletin 2019/01**

(21) Numéro de dépôt: **13782822.4**

(22) Date de dépôt: **04.09.2013**

(51) Int Cl.:
***H01L 21/67*** *(2006.01)*    ***H01L 21/20*** *(2006.01)*
***H01L 21/683*** *(2006.01)*    ***H01L 21/762*** *(2006.01)*

(86) Numéro de dépôt international:
**PCT/IB2013/001937**

(87) Numéro de publication internationale:
**WO 2014/037792 (13.03.2014 Gazette 2014/11)**

(54) **PROCÉDÉ DE SÉPARATION D'AU MOINS DEUX SUBSTRATS SELON UNE INTERFACE CHOISIE**

VERFAHREN ZUR TRENNUNG VON MINDESTENS ZWEI SUBSTRATEN ENTLANG EINER BESTIMMTEN SCHNITTSTELLE

METHOD FOR SEPARATING AT LEAST TWO SUBSTRATES ALONG A SELECTED INTERFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.09.2012 FR 1258403**

(43) Date de publication de la demande:
**15.07.2015 Bulletin 2015/29**

(73) Titulaire: **Soitec**
**38190 Bernin (FR)**

(72) Inventeurs:
• **LANDRU, Didier**
**F-38190 Le Champ-près-Froges (FR)**
• **FIGUET, Christophe**
**F-38920 Crolles (FR)**

(74) Mandataire: **Grünecker Patent- und Rechtsanwälte PartG mbB Leopoldstraße 4 80802 München (DE)**

(56) Documents cités:
**WO-A1-2010/105793    WO-A2-2006/093817
US-B1- 6 291 313**

**Description**

**DOMAINE DE L'INVENTION**

L'invention concerne un procédé de séparation d'une structure comprenant deux substrats assemblés, l'un au moins de ces deux substrats étant destiné à être utilisé dans l'électronique, l'optique, l'optoélectronique et/ou le photovoltaïque, la séparation ayant lieu le long d'une interface présente dans la structure, dite interface de séparation

**ARRIERE PLAN DE L'INVENTION**

Un cas particulier d'une telle structure est une structure « décollable » (« debondable structure » selon la terminologie anglo-saxonne), dans laquelle l'interface de séparation est une interface selon laquelle un collage par adhésion moléculaire a été réalisé.

Par « collage par adhésion moléculaire », on désigne un collage par contact intime des surfaces des deux substrats, mettant en oeuvre des forces d'adhésion, principalement les forces de Van der Walls, et n'utilisant pas de couche adhésive.

Sans vouloir être limitatif, on peut toutefois considérer qu'une structure décollable peut être utilisée principalement dans quatre applications différentes :

a) collage d'un raidisseur mécanique il peut être souhaitable de coller un raidisseur mécanique sur un substrat ou une couche mince fragile pour éviter son endommagement ou sa rupture durant certaines étapes de fabrication, puis de pouvoir retirer ce raidisseur mécanique lorsque sa présence n'est plus nécessaire.

b) rectification d'un mauvais collage : le décollement permet de décoller deux substrats qui n'auraient pas été collés correctement une première fois, puis de les recoller après nettoyage, afin d'améliorer la rentabilité d'un procédé de fabrication et d'éviter par exemple la mise au rebut de substrats mal collés.

c) protection temporaire : lors de certaines étapes de stockage ou de transport de substrats, notamment dans des boites en matière plastique, il peut être utile de protéger temporairement leurs surfaces, notamment celles destinées à être utilisées ultérieurement pour la fabrication de composants électroniques, afin d'éviter tout risque de contamination. Une solution simple consiste à coller deux substrats de façon que leurs faces à protéger soient collées respectivement l'une avec l'autre, puis à décoller ces deux substrats lors de leur utilisation finale.

d) double transfert d'une couche il consiste à réaliser une interface de collage réversible entre une couche active et un premier substrat support (éventuellement réalisé en

Cependant, il peut également se trouver des applications dans lesquelles on souhaite séparer une structure, formée de deux substrats assemblés, selon une interface qui n'est pas une interface de collage.

Une telle interface peut être, par exemple, une interface entre un premier et un second matériau, qui peuvent avoir été joints l'un à l'autre par un apport du second matériau sur le premier, par exemple par un dépôt, une épitaxie, etc.

En variante, une telle interface peut être, par exemple, une zone fragile formée à l'intérieur d'un matériau et matérialisée par la présence de bulles, d'inclusions, etc.

Une séparation selon une interface qui n'est pas une interface de collage peut notamment trouver application dans le transfert d'une couche d'un premier substrat vers un second substrat.

Ladite couche à transférer peut ainsi ne pas été formée par collage sur le premier substrat mais, par exemple, avoir été formée par épitaxie ou dépôt sur ledit substrat, ou, de manière alternative, faire partie d'une couche plus épaisse à l'intérieur de laquelle elle a été délimitée par une couche de bulles qui fragilise la couche épaisse.

Quelles que soient les applications envisagées, il est nécessaire d'effectuer cette séparation, sans endommager, rayer, ou contaminer la surface des deux substrats situés de part et d'autre de l'interface de séparation et sans casser ces deux substrats.

En fonction des différentes applications, ces deux "substrats à séparer" peuvent être deux couches d'un même substrat ou deux substrats distincts.

En outre, plus les dimensions des deux substrats de la structure à séparer sont importantes ou plus leur énergie de liaison est forte et plus la séparation est difficile à réaliser, notamment sans dommages.

On sait par ailleurs d'après les travaux de recherche de Maszara concernant la mesure de l'énergie de collage entre deux substrats, (voir l'article de W.P Maszara, G. Goetz, A. Caviglia et J.B McKitterick : J. Appl Phys. 64 (1988) 4943) qu'il est possible de mesurer l'énergie de collage entre deux substrats, en introduisant une lame mince entre les deux, au niveau de leur interface de collage.

Maszara a établi la relation suivante :

$$L = \sqrt[4]{\frac{3Et^3d^2}{32\gamma}}$$

dans laquelle d représente l'épaisseur de la lame insérée entre les deux substrats collés, t représente l'épaisseur de chacun des deux substrats collés, E représente le module de Young selon l'axe du décollement, $\gamma$ représente l'énergie de collage et L représente la longueur de la fissure entre les deux substrat à l'équilibre.

Dans la formule ci-dessus, on part de l'hypothèse que les deux substrats sont de dimensions identiques.

Grâce à la relation précitée, il est possible en mesurant L de déterminer l'énergie de collage $\gamma$.

Cette définition de l'énergie de « collage » repose sur l'hypothèse que l'énergie nécessaire pour séparer les deux substrats, ou énergie de rupture de l'interface (qui est l'énergie effectivement mesurée par la méthode utilisant une lame) est égale à l'énergie de collage desdits substrats.

En réalité, lors de la séparation des substrats, une partie de l'énergie est dissipée non dans la rupture de l'interface elle-même mais dans d'autres phénomènes, tels que des déformations du ou des matériaux présents à l'interface.

Dans la suite du texte, on désignera donc par énergie de rupture d'une interface l'énergie à fournir pour séparer deux substrats ou couches selon ladite interface.

Dans la mesure où les substrats ou couches à séparer présentent des rigidités suffisantes pour être séparés avec une lame, il est possible de les séparer en les écartant suffisamment l'un de l'autre, au niveau de leur bord chanfreiné, ce qui a pour effet de créer une onde de séparation. Celle-ci se propage depuis le point du bord des substrats où elle est initiée, à travers toute la surface de ces substrats.

Par ailleurs, il est connu d'assister la séparation par le phénomène dit de corrosion sous contrainte.

La corrosion sous contrainte consiste à combiner à l'effort d'écartement de la lame l'application d'un fluide à l'interface de séparation.

La corrosion sous contrainte est particulièrement mise à profit lorsque l'un au moins des substrats est en silicium et que l'interface comprend de l'oxyde de silicium, qu'il s'agisse d'un oxyde natif ou d'un oxyde formé intentionnellement, par exemple pour former une couche de collage ou une couche isolante.

En effet, une telle interface contient des liaisons siloxane (Si-O-Si), qui sont rompues par des molécules d'eau apportées par le fluide.

L'énergie de rupture de l'interface est ainsi notablement diminuée.

Pour la description du processus de corrosion sous contrainte, on pourra se référer au chapitre 14, intitulé "Debonding of Wafer-Bonded Interfaces for Handling and Transfer Applications" de J. Bagdahn et M. Petzold, dans l'ouvrage "Wafer Bonding: Applications and Technology" dirigé par M. Alexe et U. Gösele, Springer, 2004.

En particulier, Cha et al, dans « Why debonding is useful in SOI? », Electrochemical Society Proceedings, Vol. 99-35, pp. 119-128, proposent une séparation en deux temps, consistant à écarter partiellement les substrats au moyen d'une lame puis à introduire de l'eau déionisée dans l'intervalle ainsi formé jusqu'à la séparation complet des substrats.

Cependant, dans certaines applications, l'interface selon laquelle on souhaite effectuer la séparation présente une énergie de rupture très élevée, par exemple supérieure à 1 J/m$^2$, voire supérieure à 1,5 J/m$^2$.

Tel est le cas par exemple d'une structure de type silicium sur isolant (SOI) ou plus largement d'une structure de type semi-conducteur sur isolant (SeOI), qui comprend un substrat support, une couche diélectrique enterrée (par exemple une couche d'oxyde) et une couche semi-conductrice (de silicium dans le cas d'un SOI).

Lorsque cette structure est réalisée par transfert de couche, c'est-à-dire par assemblage d'un substrat donneur comprenant la couche semi-conductrice et du substrat support, la couche diélectrique se trouvant à l'interface, on met généralement en oeuvre un traitement thermique visant à augmenter l'énergie de rupture à l'interface.

Ceci permet d'éviter que la structure ne se sépare lors du transfert de la couche semi-conductrice ou lors des étapes ultérieures de traitement du SOI.

A titre d'exemple, on peut ainsi atteindre une énergie de rupture de l'ordre de 1,6 J/m$^2$ à l'interface.

Or, en raison de cette énergie de rupture très élevée, si l'on tente d'insérer une lame pour séparer la couche semi-conductrice, il existe un risque important de casser ladite couche au lieu de la séparer le long de l'interface.

Le document US 7,713,369 propose un procédé de fabrication d'une structure démontable constituée de l'assemblage de deux substrats, dans lequel on forme à l'interface, ici, de collage, une zone périphérique présentant une énergie de rupture élevée et une zone centrale présentant une énergie de rupture faible.

Ainsi, pour séparer les deux substrats, on retire la zone périphérique par une attaque chimique ou à l'aide d'un laser, jusqu'à atteindre la zone centrale au niveau de laquelle on peut mettre en oeuvre une séparation mécanique (par exemple, au moyen d'un jet d'eau ou d'air sous pression, par traction ou par l'insertion d'une lame).

Cependant, la formation de ces deux zones d'énergies de rupture différenciées sur une même interface est contraignante à mettre en oeuvre.

Par ailleurs, certaines structures peuvent comporter plusieurs interfaces, la séparation des substrats se faisant nécessairement au niveau de l'interface ayant la plus faible énergie de rupture. Cette interface, prédéfinie par ses caractères techniques, peut ne pas être celle qu'un utilisateur aurait choisie pour effectuer la séparation des substrats à l'endroit voulu

Le document WO 2010/105793 décrit un dispositif et une méthode associée destinés à détacher une tranche d'un substrat porteur, ladite tranche et ledit substrat porteur étant reliés par une couche de liaison.

Un but de l'invention est donc de proposer un procédé de séparation permettant de séparer deux substrats assemblés, selon une interface choisie parmi d'autres, les interfaces ayant des énergies de liaison très élevées, identiques ou différentes, sans risque de fracture ou d'endommagement desdits substrats.

**BREVE DESCRIPTION DE L'INVENTION**

Conformément à l'invention, il est proposé un procédé de séparation d'au moins deux substrats contenus dans une structure (S), la structure comprenant au moins deux interfaces de séparation s'étendant parallèlement aux faces principales de ladite structure, le long d'une interface choisie parmi lesdites interfaces, l'un au moins de ces deux substrats étant destiné à être utilisé dans l'électronique, l'optique, l'optoélectronique et/ou le photovoltaïque, ladite séparation étant réalisée par l'insertion d'une lame entre lesdits substrats et l'application par ladite lame d'un effort d'écartement des deux substrats, ledit procédé étant caractérisé en ce que :

- on choisit pour la séparation une interface sensible à la corrosion sous contrainte, c'est-à-dire à l'action combinée dudit effort d'écartement et d'un fluide susceptible de rompre des liaisons siloxane (Si-O-Si) présentes à ladite interface,
- avant l'insertion de ladite lame, on endommage au moins une partie d'une région périphérique de l'interface choisie comprenant la région d'insertion de la lame, de manière à ce que l'énergie de rupture dans ladite région périphérique soit plus faible que celle des autres interfaces dans la région d'insertion de la lame, permettant ainsi d'initier l'écartement des substrats selon l'interface choisie dans la région endommagée, puis en ce que
- l'on applique un fluide dans l'intervalle entre lesdits substrats écartés tout en poursuivant l'insertion de ladite lame, de sorte à diminuer l'énergie de rupture de l'interface choisie par corrosion sous contrainte.

Dans le présent texte, le terme "substrat" couvre un substrat mono ou multicouches et dont la périphérie présente un chanfrein sur lequel une lame peut prendre appui pour provoquer l'écartement de deux substrats collés. Par ailleurs, un substrat peut lui-même contenir une ou plusieurs interfaces.

Une interface de séparation est définie dans le présent texte comme étant une frontière physique entre deux couches, selon laquelle une onde de séparation peut se propager.

Il est entendu que les deux couches en question peuvent être en deux matériaux différents, lesdits matériaux pouvant être joints par tout type d'apport d'un matériau sur l'autre (notamment épitaxie, dépôt, collage, oxydation, notamment oxydation thermique), ou bien former deux parties d'une couche plus épaisse, délimitées par une zone fragile (notamment contenant des bulles, des inclusions, etc.).

Selon un mode de réalisation, ladite région périphérique de l'interface choisie se présente sous la forme d'une couronne.

Selon une forme d'exécution de l'invention, la région périphérique présentant une énergie de rupture plus faible est formée préalablement à l'assemblage des deux substrats.

De manière alternative, la région périphérique présentant une énergie de rupture plus faible est formée après l'assemblage des deux substrats.

Selon un mode de réalisation, la région périphérique est formée par irradiation laser de l'interface choisie.

Selon un mode de réalisation, la région périphérique est formée par attaque chimique de l'interface choisie.

Par exemple, ladite attaque chimique est réalisée par l'application d'acide fluorhydrique.

Selon une application avantageuse de l'invention, la structure comprend une structure de type semiconducteur sur isolant comprenant un substrat support, une couche d'oxyde de silicium enterrée et une couche de silicium, l'interface de séparation consistant en l'interface entre la couche d'oxyde et la couche de silicium.

L'énergie de rupture de chacune des interfaces de séparation peut être supérieure à 1 $J/m^2$, de préférence supérieure à 1,5 $J/m^2$.

De préférence, l'énergie de rupture dans ladite région périphérique de l'interface de séparation choisie est inférieure ou égale à 1 $J/m^2$.

En revanche, l'énergie de rupture dans le reste de ladite interface de séparation peut être supérieure ou égale à 1 $J/m^2$, de préférence supérieure ou égale à 1,5 $J/m^2$.

Selon un mode de réalisation particulier, ladite interface choisie est une interface silicium / oxyde de silicium.

Le fluide appliqué entre les substrats est avantageusement choisi parmi l'eau déionisée, l'éthanol, la vapeur d'eau, l'ammoniaque, et l'hydrazine.

**BREVE DESCRIPTION DES DESSINS**

D'autres caractéristiques et avantages de l'invention ressortiront de la description détaillée qui va suivre, en référence aux dessins annexés sur lesquels :

- la figure 1 est une vue en coupe d'une structure à séparer ;
- les figures 2A et 2B illustrent en vue de dessus deux modes d'endommagement de l'interface I1 ;
- les figures 3A et 3B illustrent les étapes successives de la séparation de la structure ;
- la figure 4 est une structure de type silicium sur isolant pouvant être séparée selon un exemple de mise en oeuvre de l'invention ;
- la figure 5 illustre l'insertion de la lame en vue de séparer la structure de la figure 4.

**DESCRIPTION DETAILLEE DE L'INVENTION**

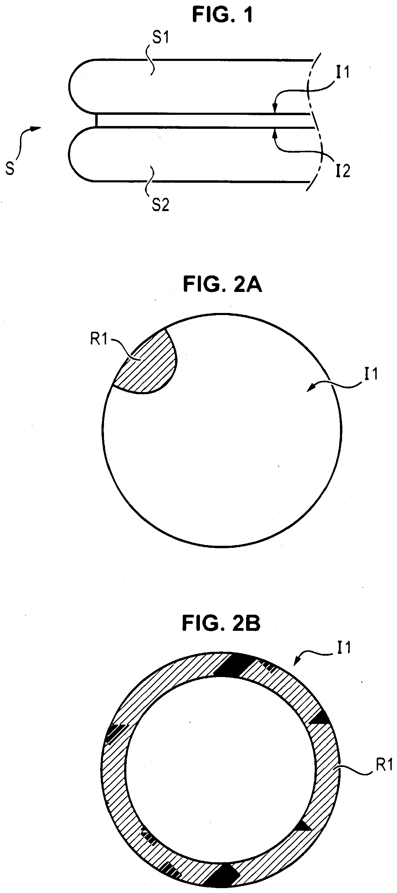

En référence à la figure 1, la structure S à séparer comprend deux substrats S1 et S2.

L'un au moins de ces substrats est destiné à être utilisé dans l'électronique, l'optique, l'optoélectronique et/ou le photovoltaïque.

La structure S comprend par ailleurs deux interfaces de séparation I1, I2 présentant respectivement des énergies de rupture $\gamma1$, $\gamma2$ (exprimées en J/m$^2$).

Comme mentionné plus haut, l'une au moins des interfaces I1 et I2 peut être une interface de collage, tandis que l'autre interface est une interface d'un autre type (par exemple, résultant d'une épitaxie, d'un dépôt, etc.).

De manière alternative, les interfaces I1 et I2 peuvent être toutes les deux des interfaces de collage.

Par exemple, les substrats S1 et S2 peuvent avoir été collés le long de l'interface I2, tandis que l'interface I1 est une interface formée lors de l'épitaxie d'un matériau sur un support, ledit matériau et le support formant ensemble le substrat S1.

On considère que c'est selon l'interface I1 que la séparation doit avoir lieu.

Naturellement, la structure pourra comprendre davantage d'interfaces sans pour autant sortir du cadre de la présente invention. On appliquera alors à chacune desdites autres interfaces l'enseignement relatif à l'interface I2.

L'interface I1 est avantageusement une interface sensible à la corrosion sous contrainte.

Plus précisément, les matériaux choisis de part et d'autre de l'interface I1 génèrent des liaisons siloxane qui sont susceptibles d'être rompues par un fluide sous l'action d'un effort d'écartement des substrats S1 et S2.

Les matériaux de part et d'autre de l'interface I1 peuvent être identiques ou différents, pour autant qu'il existe des liaisons siloxane entre lesdits matériaux.

Les interfaces qui contiennent de telles liaisons siloxane sont des interfaces mettant en jeu notamment l'oxyde de silicium (SiO$_2$), qu'il soit natif ou formé intentionnellement sur un support (par dépôt, oxydation, etc.), le silicium, lorsqu'il est assemblé par collage hydrophile, et/ou des oxynitrures de silicium.

Les moyens de générer une interface comprenant des liaisons siloxane sont très divers et incluent notamment des procédés de collage, de dépôt d'une couche d'oxyde, d'oxydation du silicium, de traitement du silicium par plasma oxygène, ou encore d'implantation d'oxygène.

Ainsi, l'interface I1 peut être une interface de collage, c'est-à-dire selon laquelle on a collé, lors de la fabrication de l'un des substrats ou de la structure, deux matériaux par adhésion moléculaire.

Par exemple, l'interface I1 peut être formée par collage de deux couches de silicium recouvertes chacune d'une couche d'oxyde natif par lesquelles elles sont en contact.

En variante, l'interface I1 peut être formée par collage d'une couche de silicium, éventuellement recouverte d'une couche d'oxyde natif, et d'une couche d'oxyde de silicium.

De manière alternative, l'interface I1 peut être formée par une autre technique que le collage.

Par exemple, l'interface I1 peut être formée par fragilisation d'une couche d'un matériau contenant des liaisons siloxane, par exemple par implantation ionique ou illumination laser.

Par ailleurs, selon un mode de réalisation avantageux de l'invention, l'interface I1 présente une énergie de rupture élevée, c'est-à-dire supérieure ou égale à 1 J/m$^2$, de préférence supérieure ou égale à 1,5 J/m$^2$.

La méthode de Maszara évoquée plus haut pour mesurer l'énergie de collage peut être appliquée de manière plus générale à la mesure de l'énergie de rupture d'une interface.

En ce qui concerne l'autre interface I2, selon laquelle on souhaite que la séparation n'ait pas lieu, elle peut être sensible ou non à la corrosion sous contrainte.

Cette autre interface I2 présente par ailleurs avantageusement une énergie de rupture élevée, qu'elle soit supérieure ou inférieure à l'énergie de rupture de l'interface I1 choisie pour effectuer la séparation.

Avant de procéder à la séparation de la structure S, on fait en sorte de fragiliser l'interface I1 dans une région périphérique comprenant la région d'insertion de la lame.

Cette fragilisation (qui se traduit par une diminution localisée de l'énergie de rupture, permettant par exemple d'atteindre une énergie de rupture inférieure ou égale à 1 J/m$^2$) est obtenue par un endommagement localisé à la périphérie de l'interface I1.

Selon un mode de réalisation, illustré à la figure 2A, la région endommagée R1 de l'interface I1 est comprise dans un secteur de la couronne périphérique de l'interface I1.

De préférence, l'amplitude angulaire de ce secteur est comprise entre 2 et 30°.

Selon un autre mode de réalisation, la région endommagée R1 de l'interface I1, dont la largeur dans la direction radiale est de préférence comprise entre 0,3 mm et 10 mm, se présente sous la forme d'une couronne périphérique.

Différents traitements permettent d'endommager la région R1 de l'interface I1 choisie.

L'homme du métier pourra choisir de mettre en oeuvre le traitement choisi avant ou après l'assemblage des substrats formant la structure S, notamment en tenant compte des conditions pratiques de mise en oeuvre du procédé de fabrication de la structure.

De manière avantageuse, le traitement est mis en oeuvre après la formation de la structure ; l'invention permet ainsi de séparer une structure même si son procédé de fabrication ne contient aucune étape dédiée à l'endommagement localisé de l'interface I1.

Selon un mode de réalisation, l'endommagement de la région R1 est obtenu par irradiation laser de l'interface I1 choisie.

Le faisceau laser est choisi de sorte à chauffer sélectivement l'interface I1 à affaiblir, provoquant un endommagement de ladite interface et par conséquent la diminution de son énergie de rupture.

Ledit endommagement peut être, par exemple, la décomposition thermique d'un matériau présent à l'interface en une phase gazeuse.

Tel est le cas notamment lorsque l'un des matériaux présents à l'interface est un polymère ou une céramique.

De manière alternative, l'endommagement de la région R1 est obtenu par une attaque chimique de l'interface I1 choisie.

Ladite attaque chimique est mise en oeuvre au moyen d'un agent de gravure permettant d'attaquer sélectivement l'un des matériaux présents à l'interface I1, sans attaquer les matériaux présents à l'interface I2.

L'homme du métier est à même de sélectionner l'agent de gravure approprié en fonction de la nature des matériaux de l'interface I1.

L'application d'ultrasons peut également être envisagée pour diminuer localement l'énergie de rupture de l'interface I1.

Quel que soit le traitement d'endommagement choisi, à l'issue de ce traitement, l'énergie de rupture dans la région R1 de l'interface I1 est inférieure à l'énergie de rupture dans le reste de l'interface, et peut être considérée comme une énergie de rupture suffisamment faible pour ne pas risquer d'occasionner de fracture des substrats lors de l'insertion de la lame et de l'amorce de séparation.

Par ailleurs, l'énergie de rupture de l'interface I1 dans la région R1 est inférieure à l'énergie de rupture de l'interface I2, au moins dans la région prévue pour l'insertion de la lame.

Ceci permet d'assurer que, lors de l'insertion de la lame, l'amorce de séparation s'effectue bien le long de l'interface I1 (qui présente localement l'énergie de rupture la plus faible) et non le long de l'interface I2.

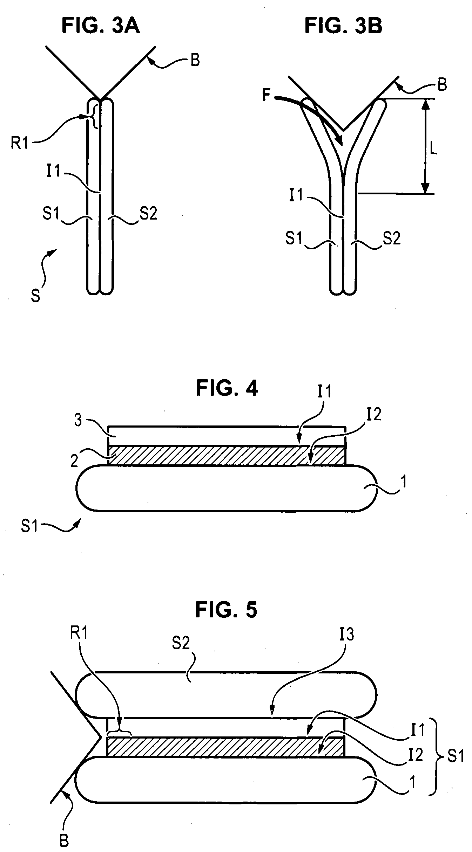

En référence à la figure 3A, la séparation consiste à insérer une lame B, de préférence épaisse, entre les deux substrats S1, S2 de la structure S, depuis la périphérie de celle-ci, et à appliquer un effort d'écartement sur les chanfreins desdits substrats.

Par épaisse, on entend le fait que la lame permet un écartement important des substrats, de sorte à permettre leur séparation physique sans entrer en contact avec les faces avant (c'est-à-dire les faces desdits substrats situées à l'interface), afin d'éviter de les endommager.

Par ailleurs, la lame doit être insérée entre les substrats selon un plan parallèle au plan de l'interface de séparation.

Lors de la séparation, les substrats sont maintenus par un support agencé de telle sorte que l'un au moins des substrats soit susceptible de se déformer, afin d'éviter toute rupture des substrats.

Ainsi, selon un mode de réalisation préféré, la structure est positionnée verticalement dans un dispositif de séparation qui comprend, dans sa partie inférieure, un organe de retenue de la structure et, dans sa partie supérieure, un organe de séparation mobile en translation verticale comprenant la lame, dans l'axe de l'organe de retenue.

L'organe de retenue comprend une gorge présentant un fond et des bords inclinés de part et d'autre dudit fond. Le fond de la gorge est suffisamment large pour recevoir la structure assemblée sans exercer de contrainte sur celle-ci, tandis que les bords sont suffisamment hauts pour éviter toute chute des substrats après leur séparation.

Le déplacement de la lame en direction de l'intérieur de la structure provoque un effet de coin et l'écartement des deux parties de celle-ci selon l'interface I1 (voir figure 3B, sur laquelle l'interface I2 n'a pas été représentée).

Cet écartement des deux parties sur une longueur L a pour effet d'initier la formation d'une onde de séparation.

Après le début de l'écartement des substrats, on applique, dans l'intervalle entre les substrats, un fluide F favorisant la corrosion sous contrainte.

Sous l'effet combiné de ce fluide F et de l'effort d'écartement exercé par la lame B, les liaisons siloxane de l'interface I1 se rompent, ce qui se traduit par une diminution sensible de l'énergie de rupture de ladite interface.

En particulier, l'énergie de rupture devient suffisamment faible pour éviter tout risque de casse des substrats lors de l'application de l'effort d'écartement.

De manière avantageuse, la structure S est maintenue en position verticale lors de la séparation.

En effet, cette position favorise le ruissellement du fluide utilisé pour la corrosion sous contrainte le long de l'interface I1.

Dans ce cas, la lame B est préférentiellement orientée verticalement et introduite au sommet de ladite structure, de sorte que l'onde séparation se déplace vers le bas en devenant horizontale au fur et à mesure qu'elle s'éloigne du point d'insertion de la lame.

Parmi les fluides favorisant la corrosion sous contrainte, on peut citer, de manière non limitative, l'eau déionisée, l'éthanol, la vapeur d'eau, l'ammoniaque et l'hydrazine.

Le fluide peut être introduit de différentes manières entre les substrats.

Ainsi, selon un mode de réalisation, la structure S peut être partiellement immergée dans un bain du fluide favorisant la corrosion sous contrainte.

De manière alternative, le fluide peut être projeté, de préférence de manière continue, sur la structure, notamment au niveau de la région d'insertion de la lame, une fois que celle-ci a été introduite entre les substrats.

Dans le cas où l'interface I2 est également sensible à la corrosion sous contrainte, il est important d'initier la contraire la séparation « à sec », c'est-à-dire en l'absence de tout fluide favorisant la corrosion sous contrainte dans la région d'insertion de la lame, et l'on attend que la séparation soit amorcée pour mettre en contact l'interface choisie avec le fluide favorisant la corrosion sous contrainte.

En effet, si l'on mettait en contact, dans la région d'insertion de la lame, les différentes interfaces sensibles à la corrosion sous contrainte avec le fluide dès l'insertion de la lame, ledit fluide aurait pour effet de diminuer l'énergie de rupture de chacune de ces interfaces, conduisant ainsi à un nivellement des énergies de rupture desdites interfaces.

En revanche, l'initiation à sec permet d'éviter un tel nivellement et d'initier la séparation selon l'interface choisie, qui présente, au moins localement, l'énergie de rupture la plus faible.

Une fois la séparation amorcée, la mise en contact de l'interface I1 choisie avec un fluide favorisant la corrosion sous contrainte permet de faciliter et d'accélérer la séparation en diminuant l'énergie de rupture de ladite interface.

On poursuit ainsi l'insertion de la lame en présence du fluide jusqu'à la séparation complète des substrats.

L'invention est particulièrement adaptée à la séparation le long des interfaces de type silicium / oxyde de silicium, et à toute autre interface sensible à la corrosion sous contrainte et présentant une énergie de rupture élevée.

La séparation décrite ci-dessus peut être obtenue sur des structures de toutes dimensions.

Notamment, la structure peut être constituée de substrats de grand diamètre, par exemple de 300 mm de diamètre.

Exemple de mise en oeuvre de l'invention

La figure 4 illustre un substrat S1 à séparer, ledit substrat étant une structure de type silicium sur isolant (SOI, acronyme du terme anglo-saxon « Silicon On Insulator »).

Le substrat S1 comprend successivement un substrat support 1, une couche 2 d'oxyde de silicium enterrée, parfois désignée par le terme « BOX » (acronyme du terme anglo-saxon « Buried OXide »), et une couche mince 3 de silicium, dite couche active, qui est généralement destinée à recevoir des composants pour l'électronique, l'optique, l'optoélectronique et/ou le photovoltaïque.

Les procédés permettant la fabrication d'un tel substrat sont bien connus de l'homme du métier.

On citera notamment les procédés de transfert de couche, et plus particulièrement le procédé Smart Cut™.

Selon un exemple de mise en oeuvre, le procédé Smart Cut™ comprend typiquement :

- la fourniture d'un substrat donneur comprenant la couche de silicium à transférer sur le substrat support,
- la formation d'une couche d'oxyde à la surface du substrat donneur (par exemple par oxydation thermique),

- l'introduction d'espèces atomiques (par exemple par implantation) dans le substrat donneur, de sorte à créer une zone de fragilisation délimitant la couche de silicium à transférer sur le substrat support,
- le collage par adhésion moléculaire de la couche d'oxyde sur le substrat support,
- la fracture du substrat donneur le long de la zone de fragilisation, conduisant au transfert de la couche de silicium sur le substrat support,
- des étapes éventuelles de finition de la couche de silicium transférée (recuit, polissage, etc.).

Le substrat S1 comprend donc deux interfaces : l'interface I1 entre la couche 3 de silicium et la couche 2 d'oxyde (qui est une interface résultant de l'oxydation du silicium), et l'interface I2 entre la couche d'oxyde 2 et le substrat support 1 (qui est une interface de collage).

L'interface silicium/oxyde I1 présente une énergie de rupture élevée, de l'ordre de 1,6 J/m$^2$.

L'énergie de cette interface peut être diminuée localement de sorte à être inférieure à l'énergie de rupture de l'interface I2 dans la région R1 de l'amorce de la séparation.

Par exemple, on peut fragiliser localement l'interface I1 par une irradiation laser ou par un traitement ultrasons.

Comme illustré à la figure 5, le substrat S1 est collé, par l'intermédiaire de la couche mince 3, à un second substrat S2 qui procure un second chanfrein d'appui pour la lame employée pour la séparation. On forme ainsi une troisième interface I3 entre la couche mince 3 et le substrat S2.

L'énergie de rupture de ladite interface I3 est choisie de sorte à être supérieure à l'énergie de rupture de l'interface I1 dans la région R1, afin d'éviter que, lors de l'insertion de la lame, la séparation ne s'effectue selon l'interface I3.

L'insertion de la lame B entre les substrats S1 et S2, dans la région endommagée R1 de l'interface I1, permet d'amorcer la séparation selon ladite interface I1, puis on applique, par exemple par projection, de l'eau déionisée dans l'intervalle entre les substrats, jusqu'au complet détachement des deux substrats.

Cette méthode permet donc de démonter la couche active d'un SOI, même lorsqu'aucune disposition n'a été prise lors de sa fabrication pour la rendre démontable.

**Revendications**

1. Procédé de séparation d'au moins deux substrats (S1, S2) faisant partie d'une structure (S) comprenant au moins deux interfaces (I1, I2) de séparation s'étendant parallèlement aux faces principales de ladite structure, le long d'une interface (I1) choisie parmi lesdites interfaces, l'un au moins de ces deux substrats étant destiné à être utilisé dans l'électronique, l'optique, l'optoélectronique et/ou le photovoltaïque, ladite séparation étant réalisée par l'insertion d'une lame (B) entre lesdits substrats (S1, S2) et l'application par ladite lame d'un effort d'écartement des deux substrats, **caractérisé en ce que** :

- on choisit pour la séparation une interface (I1) sensible à la corrosion sous contrainte, c'est-à-dire à l'action combinée dudit effort d'écartement et d'un fluide susceptible de rompre des liaisons siloxane (Si-O-Si) présentes à ladite interface (I1),
- avant l'insertion de ladite lame, on endommage au moins une partie d'une région périphérique (R1) de l'interface (I1) choisie comprenant la région d'insertion de la lame (B), de manière à ce que l'énergie de rupture dans ladite région périphérique (R1) soit plus faible que celle des autres interfaces dans la région d'insertion de la lame, permettant ainsi d'initier l'écartement des substrats (S1, S2) selon l'interface (I1) choisie dans la région endommagée (R1), puis **en ce que**
- l'on applique un fluide dans l'intervalle entre lesdits substrats (S1, S2) écartés tout en poursuivant l'insertion de ladite lame, de sorte à diminuer l'énergie de rupture de l'interface (I1) choisie par corrosion sous contrainte.

2. Procédé selon la revendication 1, **caractérisé en ce que** ladite région périphérique (R1) de l'interface choisie (I1) se présente sous la forme d'une couronne.

3. Procédé selon l'une des revendications 1 ou 2, **caractérisé en ce que** la région périphérique (R1) présentant une énergie de rupture plus faible est formée préalablement à l'assemblage des deux substrats.

4. Procédé selon l'une des revendications 1 à 3, **caractérisé en ce que** la région périphérique (R1) présentant une énergie de rupture plus faible est formée après l'assemblage des deux substrats.

5. Procédé selon l'une des revendications 1 à 4, **caractérisé en ce que** la région périphérique (R1) est formée par irradiation laser de l'interface (I1) choisie.

6. Procédé selon l'une des revendications 1 à 5, **caractérisé en ce que** la région périphérique (R1) est formée par attaque chimique de l'interface (I1) choisie.

7. Procédé selon la revendication 6, **caractérisé en ce que** ladite attaque chimique est réalisée par l'application d'acide fluorhydrique.

8. Procédé selon l'une des revendications 1 à 7, **caractérisé en ce que** la structure (S) comprend une structure de type semi-conducteur sur isolant comprenant un substrat support (1), une couche d'oxyde de silicium enterrée (2) et une couche de silicium (3), l'interface de séparation (I1) consistant en l'interface entre la couche d'oxyde (2) et la couche de silicium (3).

9. Procédé selon l'une des revendications 1 à 8, **caractérisé en ce que** l'énergie de rupture de chacune des interfaces de séparation est supérieure à 1 J/m$^2$, de préférence supérieure à 1,5 J/m$^2$.

10. Procédé selon l'une des revendications 1 à 9, **caractérisé en ce que** l'énergie de rupture dans ladite région périphérique (R1) de l'interface de séparation (I1) choisie est inférieure ou égale à 1 J/m$^2$.

11. Procédé selon l'une des revendications 1 à 10, **caractérisé en ce que** l'énergie de rupture dans le reste de l'interface de séparation (I1) est supérieure ou égale à 1 J/m$^2$, de préférence supérieure ou égale à 1,5 J/m$^2$.

12. Procédé selon l'une des revendications 1 à 11, **caractérisé en ce que** ladite interface (I1) choisie est une interface silicium / oxyde de silicium.

13. Procédé selon l'une des revendications 1 à 12, **caractérisé en ce que** le fluide appliqué entre les substrats est choisi parmi l'eau déionisée, l'éthanol, la vapeur d'eau, l'ammoniaque, et l'hydrazine.

**Patentansprüche**

1. Verfahren zur Trennung von mindestens zwei Substraten (S1, S2), die Teil einer Struktur (S) sind, die mindestens zwei Trenngrenzflächen (I1, I2) umfasst, die sich parallel zu den Hauptflächen der Struktur entlang einer unter den Grenzflächen ausgewählten Grenzfläche (I1) erstreckt, wobei mindestens eines dieser beiden Substrate zur Verwendung in der Elektronik, der Optik, der Optoelektronik und/oder der Photovoltaik bestimmt ist, wobei die Trennung durch Einführung einer Schneide (B) zwischen den Substraten (S1, S2) und Anwendung durch die Schneide einer Kraft zum Spreizen der beiden Substrate durchgeführt wird, **dadurch gekennzeichnet, dass**:

- zur Trennung eine Grenzfläche (I1) gewählt wird, die gegen Spannungsrisskorrosion, d.h. gegenüber dem kombinierten Einfluss der Spreizkraft und einer Flüssigkeit, die die an der Grenzfläche (I1) vorhandenen Siloxanbindungen (Si-O-Si) zerstören kann, empfindlich ist,

- vor der Einführung der Schneide mindestens ein Teil eines Umfangsbereichs (R1) der den Einführungsbereich der Schneide (B) umfassenden ausgewählten Grenzfläche (I1) derart beschädigt wird, dass die Bruchenergie im Umfangsbereich (R1) niedriger als die der anderen Grenzflächen im Einführungsbereich der Schneide ist, wodurch die Spreizung der Substrate (S1, S2), der im beschädigten Bereich (R1) ausgewählten Grenzfläche (I1) entsprechend, eingeleitet werden kann, und dass anschließend

- im Abstand zwischen den gespreizten Substraten (S1, S2) eine Flüssigkeit angewendet und gleichzeitig die Einführung der Schneide fortgeführt wird, um die Bruchenergie der gewählten Grenzfläche (I1) durch Spannungsrisskorrosion zu reduzieren.

2. Verfahren nach Anspruch 1, **dadurch gekennzeichnet, dass** der Umfangsbereich (R1) der gewählten Grenzfläche (1) kranzförmig ist.

3. Verfahren nach einem der Ansprüche 1 oder 2, **dadurch gekennzeichnet, dass** der eine geringere Bruchenergie aufweisende Umfangsbereich (R1) vor der Zusammenfügung der beiden Substrate gebildet wird.

4. Verfahren nach einem der Ansprüche 1 bis 3, **dadurch gekennzeichnet, dass** der eine geringere Bruchenergie aufweisende Umfangsbereich (R1) nach der Zusammenfügung der beiden Substrate gebildet wird.

5. Verfahren nach einem der Ansprüche 1 bis 4, **dadurch gekennzeichnet, dass** der Umfangsbereich (R1) durch Laserbestrahlung der gewählten Grenzfläche (I1) gebildet wird.

6. Verfahren nach einem der Ansprüche 1 bis 5, **dadurch gekennzeichnet, dass** der Umfangsbereich (R1) durch chemisches Ätzen der gewählten Grenzfläche (I1) gebildet wird.

7. Verfahren nach Anspruch 6, **dadurch gekennzeichnet, dass** der chemische Ätzvorgang durch Anwendung von Flusssäure durchgeführt wird.

8. Verfahren nach einem der Ansprüche 1 bis 7, **dadurch gekennzeichnet, dass** die Struktur (S) eine Halbleiter-auf-Isolator-artige Struktur umfasst, die ein Trägersubstrat (1), eine vergrabene Siliziumoxid-Schicht (2) und eine Silicium-Schicht (3) umfasst, wobei die Trenngrenzfläche (I1) aus der Grenzfläche zwischen der Oxidschicht (2) und der Siliziumschicht (3) besteht.

9. Verfahren nach einem der Ansprüche 1 bis 8, **dadurch gekennzeichnet, dass** die Bruchenergie jeder der Trenngrenzflächen grösser als 1 $J/m^2$, vorzugsweise grösser als 1,5 $J/m^2$ ist.

10. Verfahren nach einem der Ansprüche 1 bis 9, **dadurch gekennzeichnet, dass** die Bruchenergie im Umfangsbereich (R1) der gewählten Trenngrenzfläche (I1) kleiner oder gleich 1 $J/m^2$ ist.

11. Verfahren nach einem der Ansprüche 1 bis 10, **dadurch gekennzeichnet, dass** die Bruchenergie in der restlichen Trenngrenzfläche (I1) grösser oder gleich 1 $J/m^2$, vorzugsweise grösser oder gleich 1,5 $J/m^2$ ist.

12. Verfahren nach einem der Ansprüche 1 bis 11, **dadurch gekennzeichnet, dass** die gewählte Grenzfläche (I1) eine Silizium-/Siliziumoxid-Grenzfläche ist.

13. Verfahren nach einem der Ansprüche 1 bis 12, **dadurch gekennzeichnet, dass** die zwischen den Substraten angewendete Flüssigkeit unter entionisiertem Wasser, Ethanol, Wasserdampf, Ammoniak und Hydrazin gewählt wird.

**Claims**

1. A method for separating at least two substrates (S1, S2), which are part of a structure (S) comprising at least two separation interfaces (I1, 12) extending in parallel with the main face of said structure along an interface (I1) chosen among said interfaces, wherein at least one of these two substrates being intended for use in electronics, optics, optoelectronics and/or photovoltaics, said separation being implemented by inserting a blade (B) between said substrates (S1, S2) and applying a force by way of said blade for spreading the two substrates, **characterized in that**

- an interface (I1), that is sensitive to stress corrosion cracking, i.e. to the combined action of said spreading force and a fluid that is likely to break the siloxane bonds (Si-O-Si) located at said interface (I1), is chosen for separation,
- before inserting said blade, at least a part of a peripheral region (R1) of the chosen interface (I1), comprising the region of insertion of the blade (B), is damaged in such a manner that the impact strength in said peripheral region (R1) is weaker than that of the other interfaces in the region of insertion of the blade, thus making it possible to initiate the spreading of the substrates (S1, S2) in the damaged region (R1) in accordance with the chosen interface (I1), and subsequently **in that**

- a fluid is applied in the interval between said spread substrates (S1, S2) while continuing the insertion of said blade so as to weaken the impact strength of the chosen interface (I1) by stress corrosion cracking.

2. The method according to claim 1, **characterized in that** said peripheral region (R1) of the chosen interface (I1) is crown-shaped.

3. The method according to one of the claims 1 or 2, **characterized in that** the peripheral region (R1) having a weaker impact strength is formed before joining the two substrates.

4. The method according to one of the claims 1 to 3, **characterized in that** the peripheral region (R1) having a weaker impact strength is formed after joining the two substrates.

5. The method according to one of the claims 1 to 4, **characterized in that** the peripheral region (R1) is formed by irradiating the chosen interface (I1) with a laser.

6. The method according to one of the claims 1 to 5, **characterized in that** the peripheral region (R1) is formed by a chemical attack on the chosen interface (I1).

7. The method according to claim 6, **characterized in that** said chemical attack is implemented by applying hydrofluoric acid.

8. The method according to one of the claims 1 to 7, **characterized in that** the structure (S) comprises a structure of the semiconductor-on-insulator type comprising a support substrate (1), a buried silicon oxide layer (2) and a silicon layer (3), the separation interface (I1) consisting of the interface between the oxide layer (2) and the silicon layer (3).

9. The method according to one of the claims 1 to 8, **characterized in that** the impact strength of each of the separation interfaces is higher than 1 J/m$^2$, preferably higher than 1.5 J/m$^2$.

10. The method according to one of the claims 1 to 9, **characterized in that** the impact strength in said peripheral region (R1) of the chosen separation interface (I1) is lower or equal to 1 J/m$^2$.

11. The method according to one of the claims 1 to 10, **characterized in that** the impact strength in the rest of the separation interface (I1) is higher or equal to 1 J/m$^2$, preferably higher or equal to 1.5 J/m$^2$.

12. The method according to one of the claims 1 to 11, **characterized in that** said chosen interface (I1) is a silicon/silicon oxide interface.

13. The method according to one of the claims 1 to 12, **characterized in that** the fluid applied between the substrates is chosen among deionized water, ethanol, water vapor, ammonia and hydrazine.

# FIG. 1

# FIG. 2A

# FIG. 2B

**FIG. 3A**

**FIG. 3B**

**FIG. 4**

**FIG. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7713369 B

- WO 2010105793 A

**Littérature non-brevet citée dans la description**

- **W.P MASZARA ; G. GOETZ ; A. CAVIGLIA ; J.B MCKITTERICK.** *J. Appl Phys.,* 1988, vol. 64, 4943
- Debonding of Wafer-Bonded Interfaces for Handling and Transfer Applications. **J. BAGDAHN ; M. PET-ZOLD.** Wafer Bonding: Applications and Technology. Springer, 2004

- **CHA et al.** Why debonding is useful in SOI?. *Electrochemical Society Proceedings,* vol. 99-35, 119-128